# EUROPÄISCHE PATENTSCHRIFT

(11) **EP 2 294 638 B1**
(45) Veröffentlichungstag und Bekanntmachung des Hinweises auf die Patenterteilung: **07.08.2013**
(21) Anmeldenummer: 09775892.4
(22) Anmeldetag: 19.06.2009
(51) Int. Cl.: H01L 39/22, H01L 43/06, H01L 49/00, B82Y 10/00, H01L 29/16

(54) **DREI- ODER MEHRTORBAUELEMENT AUF BASIS DES TUNNELEFFEKTS**
TRIPLE-GATE OR MULTI-GATE COMPONENT BASED ON THE TUNNELING EFFECT
COMPOSANT TRIPLE GRILLE OU MULTIGRILLE A EFFET TUNNEL

(30) Priorität: 05.07.2008 DE 102008031819
(43) Veröffentlichungstag der Anmeldung: 16.03.2011
(73) Patentinhaber: Forschungszentrum Jülich GmbH, 52425 Jülich (DE)
(72) Erfinder: KOHLSTEDT, Hermann, 24211 Preetz (DE)
(86) Internationale Anmeldenummer: PCT/DE2009/000844
(87) Internationale Veröffentlichungsnummer: WO 2010/003395

(56) Entgegenhaltungen:
- US-A- 5 179 426
- US-A- 5 710 051
- US-A1- 2003 197 235
- SNOW E S ET AL: "A metal/oxide tunnelling transistor" SEMICONDUCTOR SCIENCE AND TECHNOLOGY IOP PUBLISHING UK, Bd. 13, Nr. 8A, August 1998 (1998-08), Seiten A75-A78, XP002567866 ISSN: 0268-1242
- KHALAFALLA M A H ET AL: "Switching of single-electron oscillations in dual-gated nanocrystalline silicon point-contact transistors" IEEE TRANSACTIONS ON NANOTECHNOLOGY, IEEE SERVICE CENTER, PISCATAWAY, NJ, US, Bd. 2, Nr. 4, 1. Dezember 2003 (2003-12-01), Seiten 271-276, XP011106894 ISSN: 1536-125X
- SOON-SOO PARK ET AL: "Fabrication of a Lateral Field Emission Triode with a High Current Density and High Transconductance Using the Local Oxidation of the Polysilicon Layer" IEEE TRANSACTIONS ON ELECTRON DEVICES, IEEE SERVICE CENTER, PISACATAWAY, NJ, US, Bd. 46, Nr. 6, 1. Juni 1999 (1999-06-01), XP011016924 ISSN: 0018-9383

## Beschreibung

Die Erfindung betrifft ein Drei- oder Mehrtorbauelement auf der Basis des quantenmechanischen Tunneleffekts.

### Stand der Technik

Ein Transistor ist ein Bauelement, dessen elektrischer Widerstand durch einen Steuerstrom oder durch eine Steuerspannung veränderlich ist. Es gibt im Wesentlichen zwei verschiedene technische Konzepte: den Bipolartransistor und den Feldeffekttransistor. Beiden Arten von Transistoren ist gemein, dass sie als Halbleiter ausgeführt werden. Der Bipolartransistor enthält eine Abfolge aus abwechselnd n- und p-dotierten Halbleiterbereichen (NPN- bzw. PNP-Transistor). Ein Steuerstrom verändert die Raumladungsdichten an den np- bzw. pn-Übergängen und verändert so die Leitfähigkeit des Transistors. Der Feldeffekttransistor besteht aus einem Halbleiter mit nur einer Dotierungsart. Durch ein über eine Gate-Elektrode vorgelegtes elektrisches Feld wird die Raumladungsdichte in diesem Halbleiter verändert, wodurch die Leitfähigkeit eines Kanals durch diesen Halbleiter moduliert wird.

Die Schaltgeschwindigkeit von Transistoren stößt an Grenzen, da die Skalierung im nm-Bereich zunehmend schwierig wird. Eine weitere Miniaturisierung wird zum Einen durch die immer aufwändiger werdende Fertigung erschwert und zum Anderen dadurch, dass aus immer kleineren Raumgebieten immer größere Verlustleistungen in Form von Wärme abgeführt werden müssen, siehe hierzu etwa "Silicon CMOS devices beyond scaling", W. Haensch et al., IBM J. Res. & Dev. 50, 329 (2006); "CMOS downscaling toward the sub-10nm", H. Iwai, Solid-State Electronics 48, 497 (2004).

Dem Stand der Technik entsprechende Vorrichtungen sind aus US 5 710 051; E. S. Snow et al., "A metal/oxide tunnelling transistor", Semiconductor Science and Technology, vol. 13, p. A75-A78, (1999); US 5 179 426; Mohammed A.H. Khalafalla et al., "Switching of Single-Electron Oscillations in Dual-Gated NanocrystaJJine Silicon Point-Contact Transistors", IEEE Transactions on Nanotechnology, vol. 2, p. 271-276, (2003); US 2003 / 0197235 A1; sowie aus Soon-Soo Park et al., "Fabrication of a Lateral Field Emission Triode with a High Current Density and High Transconductance Using the Local Oxidation of the Polysilicon Layer", IEEE Transactions on Electron Devices, vol. 46, p. 1283-1289, (1999) bekannt.

### Aufgabe und Lösung

Es ist daher die Aufgabe der Erfindung, ein alternatives Bauelement zum schnellen Schalten mit hoher Verstärkung zur Verfügung zu stellen.

Diese Aufgabe wird erfindungsgemäß gelöst durch ein Bauelement gemäß den Ansprüchen 1 oder 2. Ein Messverfahren, bei dem ein erfindungsgemäßes Bauelement eingesetzt werden kann, ist Gegenstand des Anspruchs 13.

Weitere vorteilhafte Ausgestaltungen ergeben sich jeweils aus den darauf rückbezogenen Unteransprüchen.

### Gegenstand der Erfindung

Im Rahmen der Erfindung wurde ein Drei- oder Mehrtorbauelement entwickelt. Dieses Bauelement umfasst mindestens zwei durch eine für Elektronen durchtunnelbare Lücke beabstandete Tunnelelektroden auf einem Substrat.

Erfindungsgemäß weist das Bauelement Mittel zur Beaufschlagung der Lücke mit einem derartigen elektrischen Feld auf wie durch die Ansprüche 1 oder 2 definiert.

Diese Merkmale lassen sich realisieren in einem Drei- oder Mehrtorbauelement, umfassend mindestens zwei durch eine für Elektronen durchtunnelbare Lücke beabstandete Tunnelelektroden auf einem Substrat, wobei Mittel zur Beaufschlagung der Lücke mit einem elektrischen Feld vorgesehen sind, welches Feldlinien aufweist, die den kürzesten Weg zwischen den Tunnelelektroden schneiden, ohne an einer dieser Tunnelelektroden zu enden. Daher bezieht sich die Erfindung auch auf jedes Bauelement gemäß Nebenanspruch.

Es wurde erkannt, dass ein derartiges elektrisches Feld einen besonders hohen Durchgriff auf die Tunnelwahrscheinlichkeit hat, mit der Elektronen die Lücke zwischen den Tunnelelektroden überwinden können. Die quantenmechanische Wellenfunktion der Elektronen in der Lücke wird in Ausbreitungsrichtung exponentiell gedämpft. Es wurde vom Erfinder erkannt, dass dadurch die Tunnelwahrscheinlichkeit mit der Länge des Weges, den ein Elektron in der Lücke zurücklegt, exponentiell abnimmt. Es wurde weiterhin erkannt, dass im Ergebnis bereits eine Wegverlängerung um einen Atomdurchmesser eine Änderung der Tunnelwahrscheinlichkeit, und damit auch eine Änderung eines zwischen den Tunnelelektroden fließenden Tunnelstroms, um mehrere Größenordnungen bewirkt.

Die obige technische Lehre gemäß Haupt- oder Nebenanspruch ist für den Fachmann bereits ausreichend, um das Bauelement zu realisieren. Dem Fachmann sind aus der ihm gestellten konkreten Aufgabe die zu fertigende Geometrie der Tunnelelektroden, das hierfür zu verwendende Material, die Eigenschaften eines in der Lücke eventuell vorhandenen Materials sowie die zwischen den Tunnelelektroden vorzulegende Spannung bekannt. Hieraus kann er den kürzesten Weg zwischen den Tunnelelektroden sowie die Geschwindigkeit durch die Lücke tunnelnder Elektronen mit ihm geläufigen Methoden ermitteln. Das elektrische Feld so auszurichten und zu dimensionieren, dass tunnelnde Elektronen durch dieses Feld eine Wegverlängerung in der Lücke erfahren, aber ihre Zielelektrode dennoch erreichen, ist eine Aufgabe, die mit der Dimensionierung der elektrischen Ablenkfelder in einer Kathodenstrahlröhre vergleichbar ist. Diese Aufgabe ist daher ebenfalls mit dem Fachmann geläufigen Mitteln zu lösen. Hingegen ist es der Verdienst des Erfinders, überhaupt erkannt zu haben, dass sich die Wegverlängerung tunnelnder Elektronen in der Lücke als Steuerungsinstrument für die Tunnelwahrscheinlichkeit und somit als Wirkmechanismus für einen Transistor einsetzen lässt. Nach dem Stand der Technik war es bislang nicht möglich, durch ein äußeres elektrisches Feld Einfluss auf die Tunnelwahrscheinlichkeit in einer Tunnelanordnung zu nehmen.

In einer besonders vorteilhaften Ausgestaltung der Erfindung ist das Substrat ein Isolator, wie beispielsweise MgO. Es können aber auch SiO₂, Al₂O₃ oder Si₃N₄ verwendet werden, die im Gegensatz zu MgO nicht hygroskopisch sind. Es wurde erkannt, dass das Bauelement mit einem Isolator als Substrat die Funktion eines Halbleiterbauelements aufweist, jedoch ohne einen Halbleiter auskommt. Da für seine Funktion ausschließlich das Tunneln von Elektronen durch die Lücke und die Verlängerung des Weges durch die Lücke mittels des elektrischen Feldes maßgeblich sind, kommt es auf die Eigenschaften des Substrats nicht an. Insbesondere braucht das Substrat keine Elektronenbeweglichkeit aufzuweisen. Herkömmliche Halbleiterbauelemente sind von umso höherer Qualität und Geschwindigkeit, je größer die Elektronenbeweglichkeit des Substrats ist.

Damit stehen für die Herstellung des erfindungsgemäßen Bauelements auch Materialien und Herstellungsverfahren offen, die mit der Halbleiterherstellung nicht kompatibel sind. So benötigt das Bauelement keine aufwendigen Temperschritte, wie etwa "backend annealing" in Wasserstoff. Daher ist es möglich, eine große Palette von Materialien zu verwenden.

In einer besonders vorteilhaften Ausgestaltung der Erfindung enthält das Substrat einen Kunststoff, also ein Material, das zumindest zum Teil aus Polymeren mit organischen Gruppen besteht. Ein solches Substrat kann insbesondere biegsam ausgestaltet sein. Das Bauelement ist dann ein Element der organischen Elektronik, auch Plastikelektronik genannt. Da die herkömmliche Halbleiterelektronik auf eine Elektronenbeweglichkeit im Substrat angewiesen ist und diese Beweglichkeit in organischen Materialien gering ist, arbeiten organische Halbleiterbauelemente nach dem Stand der Technik bisher sehr langsam. Das erfindungsgemäße Bauelement öffnet erstmalig den Weg zu einem Transistor mit hoher Grenzfrequenz auf einem flexiblen Substrat. Derzeit. beträgt die Grenzfrequenz für OFETs (Organic Field Effect Transistors) im Bereich von einigen 100 kHz. Für die Siliziumtechnologie beträgt die Grenzfrequenz mehrere 100 GHz. Wird ein Tunneleffekttransistor als erfindungsgemäßes Bauelement auf einem Plastiksubstrat realisiert, so liegt die Grenzfrequenz in der Größenordnung von 100 GHz, da die Elektronenbeweglichkeit als limitierender Faktor entfällt.

Prinzipiell ist jedes Metall als Elektrodenmaterial geeignet. Bei ferromagnetischen Elektroden kann die Spinpolarisation genutzt werden, um über ein angelegtes Magnetfeld die beiden Spinsorten beim Tunneln zu trennen. Dann ist das Bauelement zugleich ein spintronisches Bauelement. Die leitfähigen Elektroden können aber auch anorganische oder organische Halbleiter sein. Carbon-Nanotubes oder Graphen zeichnen sich als besonders stabile Elektrodenmaterialien aus.

In einer besonders vorteilhaften Ausgestaltung der Erfindung haben die Tunnelelektroden bei der vorgesehenen Betriebstemperatur supraleitende Eigenschaften. Der durch die Tunnelektroden gebildete Tunnelkontakt wird dadurch zu einem Josephson-Kontakt. Wird der kritische Strom I_{C} nicht überschritten (logischer "0"-Zustand), führt der durch Cooper-Paare getragene Suprastrom zu keinem Spannungsabfall. Es wurde vom Erfinder erkannt, dass sich das Element dann in einem leistungslosen und damit verlustfreien Zustand befindet. Nach Anlegen eines elektrischen Steuerfeldes wird der Josephson-Kontakt in den resistiven Zustand (logischer "1"-Zustand) geschaltet, da der kritische Strom der Lücke des Josephson-Kontakts exponentiell von der Weglänge der tunnelnden Elektronen abhängt. Der kritische Strom kann so weit abgesenkt werden, dass er kleiner ist als thermische Fluktuationen. Somit ist der Josephson-Kontakt in diesem Zustand faktisch nicht mehr supraleitend (resistiver Zustand). Der Tunnelstrom wird nun durch Fermionen, wie beispielsweise Elektronen, gebildet und nicht mehr durch Cooper-Paare, die Bosonen sind und einen makroskopischen Quantenzustand annehmen können. Es wurde vom Erfinder erkannt, dass auch in diesem Zustand im Element nur sehr wenig Verlustleistung anfällt: Ist der kürzeste Abstand zwischen den Tunnelelektroden größer als etwa 4 nm, so ist der Tunnelwiderstand sehr hoch (Größenordnung 0,1 GOhm). Bei einer angelegten Spannung von 0,1 V beträgt die Verlustleitung daher etwa 100 pW.

In einer besonders vorteilhaften Ausgestaltung der Erfindung ist in einem Prozessor, der eine Vielzahl von Transistoren umfasst, mindestens ein Transistor als erfindungsgemäßes Bauelement ausgebildet. Bevorzugt ist die Mehrzahl der Transistoren und besonders bevorzugt sind alle Transistoren des Prozessors als erfmdungsgemäße Bauelemente ausgebildet. Vorteilhaft haben in den erfmdungsgemäßen Bauelementen des Prozessors die Tunnelelektroden bei der vorgesehenen Betriebstemperatur supraleitende Eigenschaften. In einem solchermaßen ausgestalteten Prozessor vervielfacht sich der Vorteil der geringen Verlustleistung und damit Abwärme eines erfindungsgemäßen Bauelements mit der Anzahl solcher Bauelemente. Heutige Prozessoren sind mit ca. 800 x 10⁷ Transistoren aufgebaut. Der aus erfindungsgemäßen Tunneltransistoren zusammengesetzte Prozessor produziert selbst dann nur insgesamt P = 800 x 10⁷ x 100 pW = 0.8 W an Verlustleistung, wenn alle Transistoren im logischen "1 "-Zustand sind. Jeder Transistor im logischen "0"-Zustand ist von dieser Gesamtsumme sogar noch abzuziehen, da er supraleitend ist. Die zu erwartende Verlustleistung ist also für die supraleitende Ausführung etwa zwei Zehnerpotenzen kleiner als bei den derzeitigen Halbleiterprozessoren.

Das erfindungsgemäße Bauelement ist ein Tunnelbauelement, wobei die Lücke die Tunnelbarriere darstellt. Die Lücke ist vorteilhaft mit Vakuum oder einem Gas wie beispielsweise Luft gefüllt. Dadurch werden die Wahrscheinlichkeit, dass ein durch die Lücke tunnelndes Elektron gestreut wird, und damit auch das elektronische Rauschen und die Dissipationseigenschaften (Abwärme) des Bauelements vorteilhaft vermindert.

Das erfindungsgemäße Bauelement kann als sehr schneller elektronischer Schalter beziehungsweise, je nachdem wie stark der Durchgriff des elektrischen Feldes auf die Tunnelwahrscheinlichkeit dimensioniert ist, auch als Transistor wirken. Ein solcher Transistor ist wesentlich schneller als die bislang bekannten MOSFET-Transistoren. Bei diesem Typ Transistor wächst die Schaltzeit quadratisch mit der Länge des Gates. Auf dem International Electron Devices Meeting (IEDM) 2002 wurde von IBM im Labormaßstab ein MOSFET-Transistor mit einer Gate-Länge zwischen 4 und 8 nm präsentiert (Doris et al., "Extreme Scaling with Ultra-thin Silicon Channel MOSFETs", Electron Devices Meeting 2002, 267-270, ISBN 0-7803-7462-2, doi: 10.1109/IEDM.2002.1175829). Das erfindungsgemäße Bauelement lässt sich mit der derzeit verfügbaren Technik bereits mit Gate-Längen von 2-3 nm herstellen.

Ein Transistor als erfindungsgemäßes Bauelement weist eine geringere Verlustleistung auf als ein herkömmlicher Transistor und kann zudem bei höheren Temperaturen betrieben werden. Die Funktionalität herkömmlicher Transistoren beruht auf aneinander angrenzenden Halbleitern unterschiedlicher Dotierung. Mit steigender Temperatur nimmt die Interdiffusion zwischen den verschieden dotierten Bereichen, die den Transistor irreversibel schwächt oder zerstört, exponentiell zu. Dieser Einschränkung unterliegt ein als erfindungsgemäßes Bauelement realisierter Transistor ("Variable Trajectory Tunneling Transistor", VTTT, VT³) nicht mehr.

Ein als erfindungsgemäßes Bauelement realisierter Transistor weist außerdem ein Temperaturverhalten auf, das praktisch nur von der Stabilität des Elektrodenmaterials abhängt. Ansonsten ist lediglich die Temperaturabhängigkeit der Fermiverteilung für Elektronen maßgeblich für die Temperaturabhängigkeit der Tunnelwahrscheinlichkeit. Diese Temperaturabhängigkeit ist in den anwendungsrelevanten Temperaturbereichen wesentlich schwächer als bei herkömmlichen Halbleiterbauelementen. In der konventionellen Halbleiterelektronik hängen die Eigenschaften eines Halbleiters entscheidend von der Elektronenbeweglichkeit ab, die sehr stark, nämlich exponentiell, temperaturabhängig ist.

Schließlich weist ein als erfindungsgemäßes Bauelement realisierter Transistor einen viel größeren Dynamikumfang auf als ein herkömmlicher Transistor. Der maximal schaltbare Strom hängt nur davon ab, wie viele Elektronen zum Tunneln durch die Lücke bereitgestellt werden können. Dies wiederum ist abhängig von der Geometrie der Tunnelelektroden. In konventionellen Halbleiterbauelementen ist der maximal schaltbare Strom begrenzt durch die Anzahl der Ladungsträger, die in der Raumladungszone mobil sind. Dieser Vorteil eines Transistors, der als erfindungsgemäßes Bauelement realisiert ist, kommt überall dort zum Tragen, wo herkömmliche Transistoren in die Sättigung kommen und die Information, die mit ihnen eigentlich verstärkt werden sollte, verloren geht. Neben HiFi-Verstärkern zählen insbesondere auch Messverstärker zu diesen Anwendungen.

In einer besonders vorteilhaften Ausgestaltung der Erfindung umfassen die Mittel mindestens eine auf dem Substrat angeordnete Steuerelektrode. Mit einer solchen Steuerelektrode ist das Bauelement ein Dreitorbauelement. Die Tunnelwahrscheinlichkeit in der Lücke kann über eine Spannung eingestellt werden, die zwischen der Steuerelektrode und einer der Tunnelelektroden angelegt wird. Die Steuerelektrode muss nicht in einer Ebene mit den Tunnelelektroden liegen. Sie kann sich auch unterhalb oder oberhalb der durch die Tunnelelektroden und die Lücke gebildeten Ebene befinden, sofern sie nur keinen elektrischen Kontakt zu einer der Tunnelelektroden hat. So ist es etwa herstellungstechnisch einfacher, Baugruppen mit verschiedenen Funktionen, wie hier Tunnelelektroden einerseits und Steuerelektrode andererseits, in unterschiedlichen Schichten auf dem Substrat anzuordnen. Dies gilt im Besonderen, wenn die Herstellung dieser verschiedenen Baugruppen in verschiedenen Vakuumapparaturen erfolgt, zwischen denen ein Transfer nur unter Bruch des Vakuums möglich ist.

Vorteilhaft ist der Abstand der Steuerelektrode zu jeder anderen Steuerelektrode oder Tunnelelektrode größer als der kürzeste Abstand zwischen den Tunnelelektroden. Dann findet ein Tunneln von Elektronen ausschließlich zwischen den Tunnelelektroden statt, und die Steuerung der Tunnelwahrscheinlichkeit über die Steuerelektrode ist fast völlig leistungslos. Die endliche Wahrscheinlichkeit für unerwünschtes Tunneln aus der Steuerelektrode nimmt exponentiell mit dem Abstand ab, das durch die Steuerelektrode bewirkte elektrische Feld, welches den Weg der durch die Lücke tunnelnden Elektronen steuert, jedoch nur mit dem Quadrat des Abstands. Eine Vergrößerung des Abstands zur Vermeidung unerwünschten Tunnelns aus der Steuerelektrode ist somit nicht mit überproportionalen Funktionalitätseinbußen dieser Steuerelektrode verbunden. Dieser mit dem Abstand graduell zunehmende Effekt ist bereits anwendungsrelevant nutzbar, wenn der Abstand der Steuerelektrode zu jeder anderen Steuerelektrode oder Tunnelelektrode mindestens 1,1mal so groß ist wie der kürzeste Abstand zwischen den Tunnelelektroden. Er erreicht seine volle Ausprägung spätestens, wenn der Abstand der Steuerelektrode zu jeder anderen Steuerelektrode oder Tunnelelektrode mindestens 2mal so groß ist wie der kürzeste Abstand zwischen den Tunnelelektroden.

In der Erfindung sind mindestens zwei Steuerelektroden vorhanden, wobei die kürzeste Verbindungslinie zwischen den Steuerelektroden durch die Lücke hindurch tritt oder die Lücke über- oder unterquert. Dann kann die Tunnelwahrscheinlichkeit in der Lücke über eine Spannung eingestellt werden, die zwischen den Steuerelektroden angelegt wird.

Zugleich lässt sich mit dieser Ausgestaltung der Hall-Effekt besonders gut messen, sofern das Bauelement mit einem Magnetfeld beaufschlagt wird. Dieses Magnetfeld soll eine Komponente aufweisen, die vorteilhaft sowohl auf dem Tunnelstrom zwischen den Tunnelelektroden als auch auf der kürzesten Verbindungslinie zwischen den Steuerelektroden senkrecht steht. Bei gegebenem Tunnelstrom und Magnetfeld ist die zwischen den Steuerelektroden gemessene Hall-Spannung dann ein Maß für die Beweglichkeit des in der Lücke befindlichen Materials.

In einer besonders vorteilhaften Ausgestaltung der Erfindung läuft mindestens eine Tunnel- und/oder Steuerelektrode zur Lücke hin spitz zu. Dabei kann der vorderste Teil der Spitze insbesondere einen Öffnungswinkel von 30° oder weniger, bevorzugt 10° oder weniger, aufweisen. Je spitzer eine Tunnelelektrode zuläuft, d. h. je kleiner der Öffnungswinkel ihrer Spitze ist, desto stärker wird durch ein gegebenes elektrisches Feld der Weg eines durch die Lücke tunnelnden Elektrons bis zu dieser Tunnelelektrode verlängert. Über den Öffnungswinkel der Spitze lässt sich somit der Durchgriff des elektrischen Feldes auf den Tunnelstrom und somit die Verstärkung eines als Transistor wirkenden erfindungsgemäßen Bauelements steuern.

Spitzen oder auch Nanogaps aus zwei Spitzen, die aufeinander zu weisen und durch eine Lücke von etwa 2-3 nm voneinander beabstandet sind, lassen sich beispielsweise mit Elektronenstrahllithographie, mit einem fokussierten Ionenstrahl oder auch mit Methoden der Selbstorganisation herstellen.

Auf Grund des oben beispielhaft zur Messung des Hall-Effekts Gesagten bezieht sich die Erfindung auch auf ein Verfahren zur Messung der elektronischen Beweglichkeit einer Probe auf der Nanoskala mit der erfindungsgemäßen Vorrichtung. Bei diesem Verfahren wird die Probe zumindest teilweise in die Lücke zwischen den Tunnelelektroden eingebracht, und die Lücke wird mit einem Tunnelstrom beaufschlagt. Die Lücke wird außerdem mit einem Magnetfeld beaufschlagt, das eine zum Tunnelstrom senkrechte Komponente aufweist. Vorteilhaft steht dieses Magnetfeld auch auf der kürzesten Verbindungslinie zwischen den Steuerelektroden senkrecht. Die Trennung der mit dem Tunnelstrom transportierten Ladungen wird gemessen, beispielsweise über das Vorliegen einer Hall-Spannung zwischen auf dem Substrat angeordneten Steuerelektroden oder auch zwischen einer Steuerelektrode und einer Tunnelelektrode.

### Spezieller Beschreibungsteil

Nachfolgend wird der Gegenstand der Erfindung anhand von Figuren näher erläutert, ohne dass der Gegenstand der Erfindung dadurch beschränkt wird. Es ist gezeigt:
- Figur 1:: Schematische Darstellung einer Ausführungsform des erfindungsgemäßen Bauelements.
- Figur 2:: Wirkung des durch die Steuerelektroden vorgelegten elektrischen Feldes auf den Tunnelstrom durch die Lücke.
- Figur 3:: Ausgangskennlinienfeld (Teilbild a) und Eingangskennlinienfeld (Teilbild b) der in den Figuren 1 und 2 dargestellten Ausführungsform.
- Figur 4:: Alternative Ausführung der Tunnelkontakte 1a und 1 b zur Ausbildung des erfindungsgemäßen Bauelements als Schalter.
- Figur 5:: Ausgangskennlinien (Teilbild a) und Eingangskennlinie (Teilbild b) des als Schalter ausgebildeten erfindungsgemäßen Bauelements.

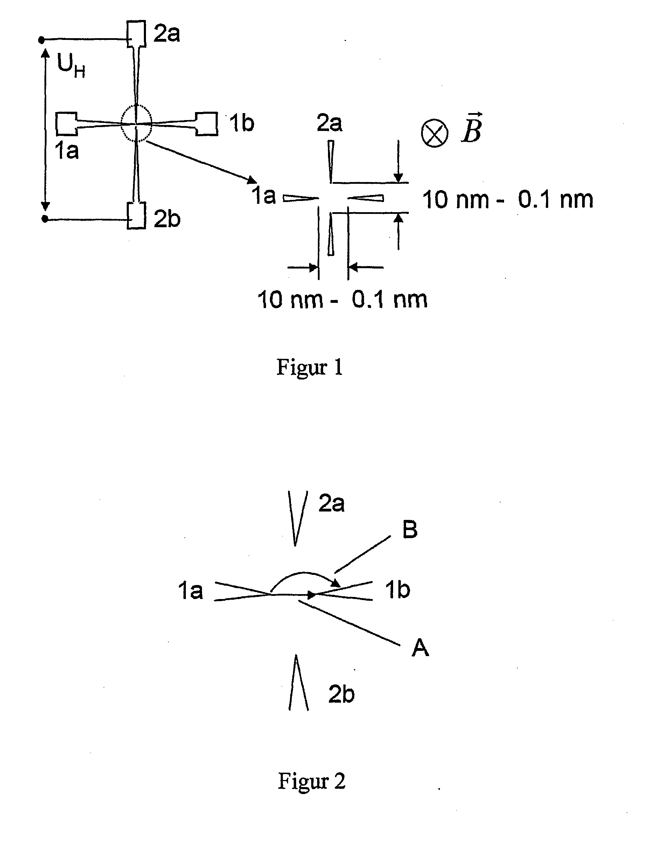

Figur 1 ist eine schematische Darstellung einer Ausführungsform des erfindungsgemäßen Bauelements, wobei der rechte Bildteil von Figur 1 eine Detailzeichnung der Region um die Lücke ist. Zwei als Spitzen ausgebildete Tunnelelektroden 1a und 1b weisen aufeinander zu, wobei zwischen ihnen eine Lücke der Größenordnung 10 nm bis 0,1 nm besteht. Ebenso weisen zwei als Spitzen ausgebildete Steuerelektroden 2a und 2b aufeinander zu, zwischen denen ein Abstand der Größenordnung 10 nm bis 0,1 nm besteht. Das Bauelement ist somit ein Viertorbauelement. Die kürzeste Verbindungslinie zwischen den Steuerelektroden 2a und 2b tritt durch die Lücke hindurch. Die Steuerelektroden 2a und 2b können verwendet werden, um die Lücke mit einem elektrischen Feld zu beaufschlagen, das den Weg eines durch die Lücke tunnelnden Elektrons verlängert. Sofern das Bauelement zusätzlich mit einem Magnetfeld 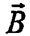 beaufschlagt wird, das eine Komponente senkrecht zur Zeichenebene aufweist, kann zwischen den Steuerelektroden eine Hall-Spannung U_{H} abgegriffen werden. Diese Hall-Spannung U_{H} ist ein Maß für die Elektronenbeweglichkeit des in der Lücke befindlichen Materials. Somit kann dann mit dem Bauelement auch das erfindungsgemäße Verfahren durchgeführt werden.

Figur 2 verdeutlicht das Prinzip, nach dem das von den Steuerelektroden 2a und 2b vorgelegte elektrische Feld den Tunnelstrom zwischen den Tunnelelektroden 1a und 1b steuert. Liegt zwischen den Steuerelektroden 2a und 2b keine Spannung an, bewegen sich die durch die tunnelnden Elektronen auf dem kürzesten Weg A durch die Lücke. Liegt dagegen eine Spannung an, führt diese zu einem elektrischen Feld in der Lücke. Die tunnelnden Elektronen werden abgelenkt und bewegen sich auf dem längeren Weg B durch die Lücke. Dadurch wird die Wahrscheinlichkeit, dass sie überhaupt zwischen den Elektroden 1a und 1b tunneln, und damit auch der Tunnelstrom zwischen diesen Elektroden, vermindert.

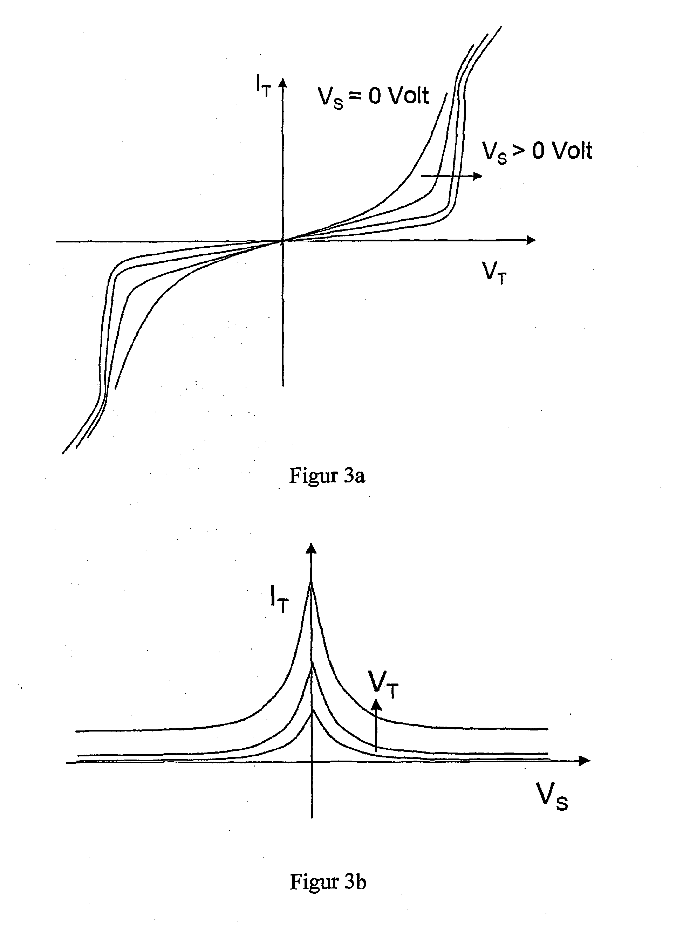

Figur 3a skizziert qualitativ das Ausgangskennlinienfeld der in den Figuren 1 und 2 dargestellten Ausführungsform des erfindungsgemäßen Bauelements. Aufgetragen ist der Tunnelstrom I_{T} über der zwischen den Tunnelektroden 1a und 1 b vorgelegten Biasspannung V_{T} für verschiedene Werte der zwischen den Steuerelektroden 2a und 2b angelegten Steuerspannung V_{S}. Im rechten oberen Quadranten von Figur 3a entspricht die am weitesten links verlaufende Kurve einer Steuerspannung V_{S} von 0 Volt; weiter rechts in der Schar verlaufende Kurven entsprechen höheren Steuerspannungen V_{S}.

Für eine Steuerspannung V_{S} von 0 Volt ist der Tunnelstrom I_{T} durchweg am größten, da die durch die Lücke tunnelnden Elektronen sich immer auf dem kürzestmöglichen Weg bewegen. Je größer die betragsmäßige Steuerspannung V_{S}, desto länger ist der Weg der Elektronen durch die Lücke und desto kleiner ist daher bei gleicher Biasspannung V_{T} der Tunnelstrom I_{T}. Ab einem kritischen Wert von V_{T}, der mit zunehmender betragsmäßiger Steuerspannung V_{S} ebenfalls betragsmäßig steigt, steigt die Stärke des Tunnelstroms I_{T} steil an, weil dann das durch die Biasspannung V_{T} vorgelegte elektrische Feld dominiert und ungeachtet des durch die Steuerspannung V_{S} bewirkten Feldes immer mehr Elektronen auf dem kürzesten Weg durch die Lücke treibt. Für große V_{T} nähert sich die Kennlinie daher asymptotisch der Kennlinie für den Fall V_{S}=0 Volt.

Im Vergleich zur Kennlinie herkömmlicher Transistoren fällt auf, dass der erfindungsgemäße Transistor in einem kleineren Bereich der Biasspannung V_{T}, die der Drain-Source-Spannung in einem FET entspricht, ein lineares Verhalten des Tunnelstroms I_{T}, der dem Source-Drain-Strom in einem FET entspricht, zeigt. Dies ist dem Umstand geschuldet, dass der quantenmechanische Tunneleffekt, der die Grundlage für das Funktionieren des erfindungsgemäßen Bauelements ist, ein stark nichtlinearer Effekt ist. Andererseits weist die Kennlinie des erfindungsgemäßen Bauelements aber auch nicht den für herkömmliche Transistoren üblichen Übergang in die Sättigung für höhere Biasspannungen V_{T} auf. Somit ist insgesamt, unter Inkaufnahme der Nichtlinearität, ein deutlich größerer Dynamikbereich nutzbar als mit herkömmlichen Transistoren. Es wird keine Information durch den Übergang in die Sättigung "abgeschnitten". Dies ist insbesondere bei HiFi-Anwendungen und Messverstärkern von Vorteil.

Die Kennlinien sind jeweils Polynome dritten Grades, die näherungsweise Lösungen der zeitabhängigen Schrödingergleichung sind.

Figur 3b zeigt das zu Figur 3a korrespondierende Eingangskennlinienfeld. In dieser Darstellung ist der Tunnelstrom I_{T} über der Steuerspannung V_{S} aufgetragen, wobei für jede der Kurven die Biasspannung V_{T} konstant ist. Höher verlaufende Kurven entsprechen höheren Werten der Biasspannung V_{T}. Der maximale Tunnelstrom I_{T} ergibt sich jeweils für eine Steuerspannung V_{S} von 0 Volt, weil dann die durch die Lücke tunnelnden Elektronen keine Wegverlängerung erfahren und somit die Wahrscheinlichkeit für das Tunneln insgesamt am größten ist. Mit zunehmender betragsmäßiger Steuerspannung V_{S} fällt der Tunnelstrom I_{T} jeweils exponentiell ab, wobei dieser Abfall umso steiler erfolgt, je größer die Biasspannung V_{T} ist. Die Biasspannung V_{T} regelt somit die Verstärkung eines über die Steuerspannung V_{S} zugeführten Signals.

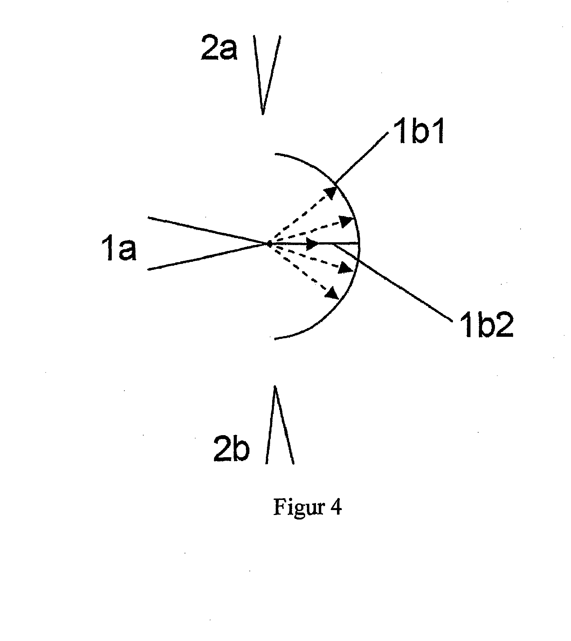

Figur 4 zeigt eine alternative Ausführungsform der Tunnelelektrode 1b, mit der das erfindungsgemäße Bauelement als Schalter ausgebildet werden kann. Die Tunnelelektrode 1b umfasst einen Basiskörper 1b1 und einen mit ihm leitend verbundenen, in Richtung der Tunnelelektrode 1a weisenden Vorkontakt 1b2. Der Basiskörper 1b2 weist nun eine derartige Formgebung auf, dass seine gesamte zur Tunnelelektrode 1a weisende Oberfläche den gleichen kürzesten Abstand zur Tunnelelektrode 1a hat. Beispielsweise kann der Basiskörper 1b1 kreisbogenförmig ausgebildet sein, und die Tunnelelektrode 1a kann sich im Mittelpunkt des Kreisbogens befinden.

Ist keine Steuerspannung V_{S} angelegt, so werden alle zwischen den Kontakten 1 a und 1b tunnelnden Elektronen den kürzesten Weg durch die Lücke einschlagen und auf den Vorkontakt 1b2 treffen (durchgezogener Pfeil). Wird die Steuerspannung V_{S} ausgehend von Null betragsmäßig erhöht, so werden immer mehr Elektronen abgelenkt, so dass sie den Vorkontakt 1b2 verfehlen und auf den Basiskörper 1b1 treffen (gestrichelte Pfeile). Dabei erfährt unabhängig vom Wert der Steuerspannung V_{S} jedes Elektron, das den Vorkontakt 1b2 verfehlt, die gleiche Wegverlängerung bis zum Auftreffen auf den Basiskörper 1b1. Der Wert der Steuerspannung entscheidet somit nur darüber, welcher Anteil der tunnelnden Elektronen den Vorkontakt 1b2 verfehlt. Ist die Steuerspannung V_{S} erst einmal betragsmäßig so hoch, dass alle Elektronen den Vorkontakt 1b2 verfehlen, ändert sich bei weiterer Erhöhung der Steuerspannung V_{S} die Tunnelwahrscheinlichkeit und somit auch der Tunnelstrom nicht mehr. Somit existieren im Wesentlichen zwei stabile Zustände für V_{S}=0 Volt und für V_{S}≠0 Volt. Dies ist das Charakteristikum eines Schalters.

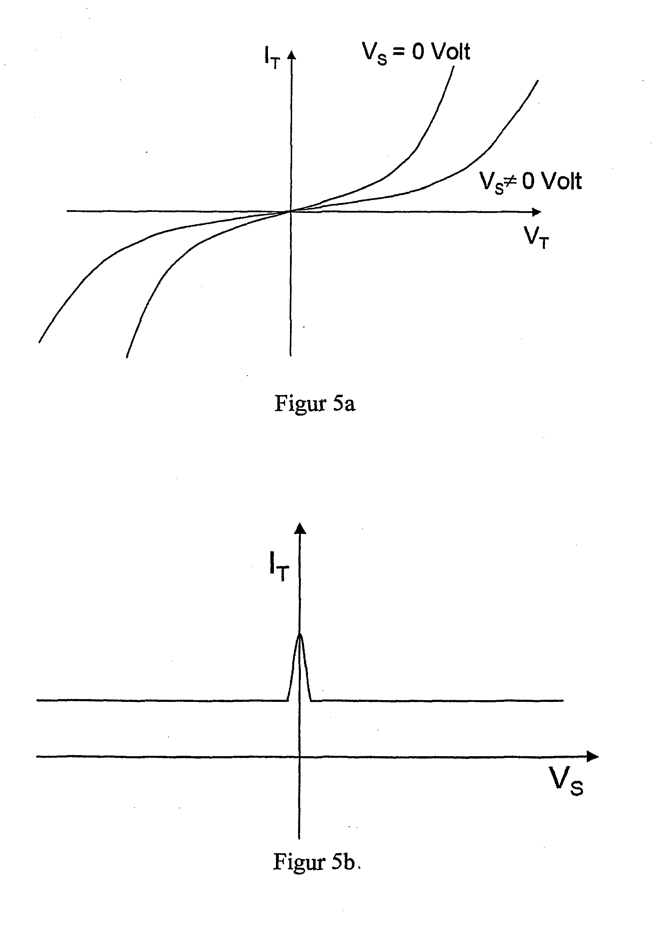

Figur 5a zeigt die Ausgangskennlinien einer Ausführungsform des erfindungsgemäßen Bauelements, in der die in Figur 4 gezeigte Anordnung der Tunnelelektroden 1a und 1b verwendet wird. Es ist der Tunnelstrom I_{T} über der Biasspannung V_{T} aufgetragen. Es gibt genau zwei verschiedene Kennlinien für V_{S}=0 Volt und für V_{S}≠0 VoltDie geringfügige Spannung V_{S}, die erforderlich ist, damit alle tunnelnden Elektronen den Vorkontakt 1b2 verfehlen, bleibt in dieser Darstellung unberücksichtigt. Der genaue Wert dieser geringfügigen Spannung hängt von geometrischen Faktoren ab, aber auch von der Biasspannung V_{T}, die die Geschwindigkeit der tunnelnden Elektronen bestimmt.

Figur 5b zeigt die Eingangskennlinie der auch in Figur 5a behandelten Ausführungsform. Der Tunnelstrom I_{T} ist über der Steuerspannung V_{S} exemplarisch für eine Biasspannung V_{T} aufgetragen. Der Tunnelstrom I_{T} ist am größten, wenn keine Steuerspannung V_{S} anliegt, weil dann alle Elektronen auf den Vorkontakt 1b2 treffen. Mit zunehmender betragsmäßiger Spannung Vs verfehlt ein immer größerer Anteil der tunnelnden Elektronen den Vorkontakt 1b2 und erfährt die Wegverlängerung bis zum Basiskörper 1b1. Dies macht sich als linearer Abfall der mittleren Tunnelwahrscheinlichkeit und daher auch des Tunnelstroms I_{T} bemerkbar. Verfehlen erst einmal alle Elektronen den Vorkontakt 1b2, treffen sie also alle auf den Basiskörper 1b1, ändert sich bei einer weiteren betragsmäßigen Erhöhung der Spannung V_{S} nichts mehr an den Weglängen der Elektronen. Daher bleibt auch der Tunnelstrom I_{T} konstant.

## Patentansprüche

1. Drei- oder Mehrtorbauelement, umfassend mindestens zwei durch eine für Elektronen durchtunnelbare Lücke beabstandete Tunnelelektroden auf
einem Substrat sowie Mittel zur Beaufschlagung der Lücke mit einem derartigen elektrischen Feld, dass die Tunnelwahrscheinlichkeit für zwischen den Tunnelelektroden tunnelnde Elektronen infolge Ablenkung durch dieses Feld vermindert wird,
**dadurch gekennzeichnet, dass**
die Mittel mindestens zwei auf dem Substrat angeordnete Steuerelektroden umfassen, wobei die kürzeste Verbindungslinie zwischen den Steuerelektroden durch die Lücke hindurch tritt oder die Lücke über- oder unterquert.

2. Drei- oder Mehrtorbauelement, umfassend mindestens zwei durch eine für Elektronen durchtunnelbare Lücke beabstandete Tunnelelektroden auf einem Substrat sowie Mittel zur Beaufschlagung der Lücke mit einem elektrischen Feld, welches Feldlinien aufweist, die den kürzesten Weg zwischen den Tunnelelektroden schneiden, ohne an einer dieser Tunnelelektroden zu enden,
**dadurch gekennzeichnet, dass**
die Mittel mindestens zwei auf dem Substrat angeordnete Steuerelektroden umfassen, wobei die kürzeste Verbindungslinie zwischen den Steuerelektroden durch die Lücke hindurch tritt oder die Lücke über- oder unterquert.

3. Bauelement nach Anspruch 1 oder 2,
**dadurch gekennzeichnet, dass**
das Substrat ein Isolator ist.

4. Bauelement nach einem der Ansprüche 1 bis 3,
**dadurch gekennzeichnet, dass**
das Substrat einen Kunststoff enthält.

5. Bauelement nach einem der Ansprüche 1 bis 4,
**dadurch gekennzeichnet, dass**
sich in der Lücke ein Vakuum befindet oder aber diese Lücke mit einem Gas gefüllt ist.

6. Bauelement nach einem der Ansprüche 1 bis 5,
**dadurch gekennzeichnet, dass**
die Tunnelelektroden bei der vorgesehenen Betriebstemperatur supraleitende Eigenschaften haben.

7. Bauelement nach einem der Ansprüche 1 bis 6,
**dadurch gekennzeichnet, dass**
der kürzeste Abstand der Steuerelektrode zu jeder anderen Steuerelektrode oder Tunnelelektrode größer ist als der kürzeste Abstand zwischen den Tunnelelektroden.

8. Bauelement nach einem der Ansprüche 1 bis 7,
**dadurch gekennzeichnet, dass**
mindestens eine Tunnel- und/oder Steuerelektrode zur Lücke hin spitz zuläuft.

9. Bauelement nach Anspruch 8,
**dadurch gekennzeichnet, dass**
der vorderste Teil der Spitze einen Öffnungswinkel von 30° oder weniger, bevorzugt 10° oder weniger, aufweist.

10. Elektronischer Schalter,
**dadurch gekennzeichnet, dass**
er als Bauelement nach einem der Ansprüche 1 bis 9 ausgebildet ist.

11. Transistor,
**dadurch gekennzeichnet, dass**
er als Bauelement nach einem der Ansprüche 1 bis 9 ausgebildet ist.

12. Prozessor, umfassend eine Vielzahl von Transistoren,
**dadurch gekennzeichnet, dass**
er mindestens einen Transistor nach Anspruch 11 enthält.

13. Verfahren zur Messung der elektronischen Beweglichkeit einer Probe auf der Nanoskala unter Verwendung eines Dreitorbauelements mit mindestens zwei durch eine für Elektronen durchtunnelbare Lücke beabstandeten Tunnelelektroden auf einem Substrat sowie Mitteln zur Beaufschlagung der Lücke mit einem elektrischen Feld, das
● die Tunnelwahrscheinlichkeit für zwischen den Tunnelelektroden tunnelnde Elektronen infolge Ablenkung durch dieses Feld vermindert und/oder
● Feldlinien aufweist, die den kürzesten Weg zwischen den Tunnelelektroden schneiden, ohne an einer dieser Tunnelelektroden zu enden,
mit den Schritten:
● die Probe wird zumindest teilweise in die Lücke zwischen den Tunnelelektroden eingebracht;
● die Lücke wird mit einem Tunnelstrom beaufschlagt;
● die Lücke wird mit einem Magnetfeld beaufschlagt, das eine Komponente senkrecht zum Tunnelstrom aufweist;
● die Trennung der mit dem Tunnelstrom transportierten Ladungen wird gemessen.

14. Verfahren nach Anspruch 13, **dadurch gekennzeichnet, dass** ein Dreitorbauelement nach einem der Ansprüche 1 bis 9 gewählt wird.

## Claims

1. Triple-gate or multiple-gate component comprising at least two tunnel electrodes spaced apart with a gap that can be tunnelled through by electrons, on a substrate, and means for subjecting the gap to an electrical field such that the tunnelling probability for electrons tunnelling between the tunnel electrodes is reduced as a result of deflection by the said field, **characterized in that**
the said means comprise at least two gates electrodes disposed on the substrate with the shortest connecting line between the gate electrodes passing through the gap or crossing over or under the gap.

2. Triple-gate or multiple-gate component comprising at least two tunnel electrodes spaced apart with a gap that can be tunnelled through by electrons, on a substrate, and means for subjecting the gap to an electrical field which has field lines that intersect the shortest path between the tunnel electrodes without terminating at one of the said tunnel electrodes, **characterized in that**
the said means comprise at least two gate electrodes disposed on the substrate with the shortest connecting line between the gate electrodes passing through the gap or crossing over or under the gap.

3. Component according to Claim 1 or Claim 2,
**characterized in that**
the substrate is an insulator.

4. Component according to any one of Claims 1 to 3,
**characterized in that**
the substrate contains a plastic material.

5. Component according to any one of Claims 1 to 4,
**characterized in that**
the gap contains a vacuum, or else is gas-filled.

6. Component according to any one of Claims 1 to 5,
**characterized in that**
the tunnel electrodes have superconducting properties at the intended operating temperature.

7. Component according to any one of Claims 1 to 6,
**characterized in that**
the shortest distance from the gate electrode to every other gate electrode or tunnel electrode is greater than the shortest distance between the tunnel electrodes.

8. Component according to any one of Claims 1 to 7,
**characterized in that**
at least one tunnel and/or gate electrode tapers to a point in the direction towards the gap.

9. Component according to Claim 8
**characterized in that**
the tip of the point has an apex angle of 30° or less, preferably 10° or less.

10. Electronic switch
**characterized in that**
it is configured as a component according to any one of Claims 1 to 9.

11. Transistor
**characterized in that**
it is configured as a component according to any one of Claims 1 to 9.

12. Processor comprising a plurality of transistors,
**characterized in that**
it contains at least one transistor according to Claim 11.

13. Method for measuring the electron mobility of a specimen on the nanoscale using a triple-gate component with at least two tunnel electrodes spaced apart with a gap that can be tunnelled through by electrons, on a substrate, and means for subjecting the gap to an electrical field which
reduces the tunnelling probability for electrons tunnelling between the tunnel electrodes as a result of deflection by the said field, and/or
has field lines that intersect the shortest path between the tunnel electrodes without terminating at one of the said tunnel electrodes,
with the steps of:
placing the specimen at least partly in the gap between the tunnel electrodes; subjecting the gap to a tunnel current;
subjecting the gap to a magnetic field with a component perpendicular to the tunnel current;
measuring the separation of the charges transported with the tunnel current.

14. Method according to Claim 13, **characterized in that** a triple-gate component according to any one of Claims 1 to 9 is selected.

## Revendications

1. Composant triple grille ou multigrille, comprenant au moins deux électrodes tunnel séparées par un espace traversable par des électrons par effet tunnel sur un substrat, ainsi qu'un moyen pour soumettre l'espace à un champ électrique qui permette de réduire la probabilité de tunnel pour les électrons soumis à effet tunnel entre les électrodes tunnel du fait de la déflexion par ledit champ,
**caractérisé en ce que**
le moyen comprend au moins deux électrodes de commande disposées sur le substrat, la ligne de connexion la plus courte entre les électrodes de commande traversant l'espace ou passant par-dessus ou par-dessous celui-ci.

2. Composant triple grille ou multigrille, comprenant au moins deux électrodes tunnel séparées par un espace traversable par des électrons par effet tunnel sur un substrat, ainsi qu'un moyen pour soumettre l'espace à un champ électrique comportant des lignes de champ croisant le trajet le plus court entre les électrodes tunnel, sans se terminer sur une desdites électrodes tunnel,
**caractérisé en ce que**
le moyen comprend au moins deux électrodes de commande disposées sur le substrat, la ligne de connexion la plus courte entre les électrodes de commande traversant l'espace ou passant par-dessus ou par-dessous celui-ci.

3. Composant selon la revendication 1 ou 2,
**caractérisé en ce que**
le substrat est un isolant.

4. Composant selon l'une des revendications 1 à 3,
**caractérisé en ce que**
le substrat contient une matière synthétique.

5. Composant selon l'une des revendications 1 à 4,
**caractérisé en ce que**
un vide se trouve dans l'espace, ou bien **en ce que** ledit espace est rempli d'un gaz.

6. Composant selon l'une des revendications 1 à 5,
**caractérisé en ce que**
les électrodes tunnel ont des propriétés supraconductrices à la température de fonctionnement prévue.

7. Composant selon l'une des revendications 1 à 6,
**caractérisé en ce que**
la plus courte distance de l'électrode de commande à chaque autre électrode de commande ou électrode tunnel est supérieure à la plus courte distance entre les électrodes tunnel.

8. Composant selon l'une des revendications 1 à 7,
**caractérisé en ce que**
au moins une électrode tunnel et/ou une électrode de commande s'étend en pointe vers l'espace.

9. Composant selon la revendication 8,
**caractérisé en ce que**
la partie avant de la pointe présente un angle d'ouverture inférieur ou égal à 30°, préférentiellement inférieur ou égal à 10°.

10. Commutateur électronique,
**caractérisé en ce que**
il est réalisé sous forme de composant selon l'une des revendications 1 à 9.

11. Transistor,
**caractérisé en ce que**
il est réalisé sous forme de composant selon l'une des revendications 1 à 9.

12. Processeur, comprenant une pluralité de transistors,
**caractérisé en ce que**
il contient au moins un transistor selon la revendication 11.

13. Procédé de mesure de la mobilité électronique d'un échantillon à l'échelle nanométrique, recourant à un composant triple grille avec au moins deux électrodes tunnel séparées par un espace traversable par des électrons par effet tunnel sur un substrat, ainsi qu'un moyen pour soumettre l'espace à un champ électrique
● qui permette de réduire la probabilité de tunnel pour les électrons soumis à effet tunnel entre les électrodes tunnel du fait de la déflexion par ledit champ, et/ou
● qui comporte des lignes de champ croisant le trajet le plus court entre les électrodes tunnel, sans se terminer sur une desdites électrodes tunnel,
ledit procédé comportant les étapes suivantes :
● l'échantillon est au moins partiellement mise en place dans l'espace entre les électrodes tunnel ;
● l'espace est soumis à un courant de tunnel ;
● l'espace est soumis à un champ magnétique ayant une composante perpendiculaire au courant de tunnel ;
● la séparation des charges transportées par le courant de tunnel est mesurée.

14. Procédé selon la revendication 13, **caractérisé en ce qu'**un composant triple grille selon l'une des revendications 1 à 9 est sélectionné.
